# EUROPEAN PATENT APPLICATION

(11) **EP 4 701 360 A1**
(43) Date of publication of application: **25.02.2026**
(21) Application number: 24905399.2
(22) Date of filing: 08.05.2024
(51) Int. Cl.: H10B 12/00

(54) **SEMICONDUCTOR STRUCTURE AND MANUFACTURING METHOD THEREFOR**

(30) Priority: 19.12.2023 CN 202311760110
(71) Applicant: CXMT Corporation, Hefei City, Anhui Province 230601 (CN)
(72) Inventor: FANG, Qingchun, Hefei, Anhui 230601 (CN)
(74) Representative: Gulde & Partner
(86) International application number: PCT/CN2024/091606
(87) International publication number: WO 2025/129895

(57) **Abstract**

A semiconductor structure and a manufacturing method therefor are provided, including: a first stacked structure, the first stacked structure having a first surface for bonding; the first stacked structure including a transistor array and a charge storage array, the transistor array and the charge storage array being stacked in a direction perpendicular to the first surface, and the transistor array being closer to the first surface than the charge storage array, where the charge storage array has a first connection terminal and a second connection terminal, the first connection terminal is configured to connect the charge storage array and the transistor array, and the second connection terminal surrounds the outer periphery of the transistor array and the charge storage array and extends to the vicinity of the first surface. Embodiments of the present disclosure can simultaneously improve integrated density and reliability of a storage circuit.

## Description

### CROSS-REFERENCE TO RELATED APPLICATIONS

The present disclosure claims priority to Chinese Patent Application No. 202311760110.3, filed with the China National Intellectual Property Administration on December 19, 2023 and entitled "SEMICONDUCTOR STRUCTURE AND MANUFACTURING METHOD THEREFOR", which is incorporated herein by reference in its entirety.

### TECHNICAL FIELD

The present disclosure relates to the field of integrated circuit manufacturing technologies, and specifically, to a semiconductor structure and a manufacturing method therefor.

### BACKGROUND

With the increasing demands for storage density, the vertical channel transistor (VCT) technology exists in related technologies. In the VCT technology, it is necessary to connect storage capacitors at first terminals of multiple transistors disposed perpendicular to the surface of a substrate, and connect bitlines at second terminals of the transistors. This results in control of the transistors and capacitors being achieved by passing through at least one long conductive line, which is inefficient for control, and leads to denser conductive lines when the quantities of transistors and capacitors are high, and the dense conductive lines bring a trouble for processing and element layout when there is a miniaturization trend of memories.

It should be noted that the information disclosed in the background part is only for enhancing understanding of the background of the present disclosure, and therefore may include information that does not constitute the prior art known to a person of ordinary skill in the art.

### SUMMARY

The present disclosure aims to provide a semiconductor structure and a manufacturing method therefor, so as to resolve a control line layout problem of a vertical channel transistor.

According to a first aspect of the present disclosure, a semiconductor structure is provided, including: a first stacked structure, the first stacked structure having a first surface for bonding; the first stacked structure including a transistor array and a charge storage array, the transistor array and the charge storage array being stacked in a direction perpendicular to the first surface, and the transistor array being closer to the first surface than the charge storage array, where the charge storage array has a first connection terminal and a second connection terminal, the first connection terminal is configured to connect the charge storage array and the transistor array, and the second connection terminal surrounds the outer periphery of the transistor array and the charge storage array and extends to the vicinity of the first surface.

In an example embodiment of the present disclosure, the first stacked structure further includes a first circuit wiring layer, the first circuit wiring layer is connected to the second connection terminal of the charge storage array and the transistor array, and the first circuit wiring layer is closer to the first surface than the transistor array.

In an example embodiment of the present disclosure, the first surface has a first interconnection contact pad array connected to the transistor array and a second interconnection contact pad array connected to the second connection terminal, the first interconnection contact pad array extends through the first surface to connect to the transistor array, and the second interconnection contact pad array extends through the first surface to connect to the second connection terminal.

In an example embodiment of the present disclosure, the second interconnection contact pad array is formed on the outer periphery of the first interconnection contact pad array.

In an example embodiment of the present disclosure, the charge storage array includes multiple storage capacitors, and the second connection terminal includes: a first conductive layer, connected to top electrodes of the multiple storage capacitors; and a second conductive layer, covering and connected to the first conductive layer and surrounding the outer periphery of the transistor array and the charge storage array.

In an example embodiment of the present disclosure, the semiconductor structure further includes a second stacked structure, where the second stacked structure has a second surface, and the second surface of the second stacked structure is configured to bond to the first surface of the first stacked structure.

In an example embodiment of the present disclosure, the second stacked structure includes a substrate and a control circuit disposed on the substrate, the control circuit is closer to the second surface of the second stacked structure than the substrate, the control circuit is configured to connect to the transistor array, and the substrate is configured to connect to the second connection terminal of the charge storage array.

In an example embodiment of the present disclosure, the second stacked structure further includes a second circuit wiring layer, the second circuit wiring layer is connected to the control circuit and the substrate, and the second circuit wiring layer is closer to the second surface of the second stacked structure than the control circuit.

In an example embodiment of the present disclosure, a third interconnection contact pad array and a fourth interconnection contact pad array are disposed on the second surface of the second stacked structure, the third interconnection contact pad array is configured to connect the transistor array and the control circuit, and the fourth interconnection contact pad array is configured to connect the second connection terminal of the charge storage array and the substrate.

In an example embodiment of the present disclosure, the fourth interconnection contact pad array surrounds the third interconnection contact pad array.

In an example embodiment of the present disclosure, a second circuit wiring layer includes a third contact structure and a fourth contact structure, the third contact structure is configured to connect the third interconnection contact pad array and the control circuit, and the fourth contact structure is configured to connect the fourth interconnection contact pad array and the substrate.

According to a second aspect of the present disclosure, a manufacturing method for a semiconductor structure is provided, including: forming a transistor array on a base; forming a charge storage array on the transistor array, the charge storage array having a first connection terminal and a second connection terminal, the first connection terminal being configured to connect the charge storage array and the transistor array, and the second connection terminal surrounding the outer periphery of the transistor array and the charge storage array and extending to the vicinity of the base; and removing the base to form a first stacked structure.

In an example embodiment of the present disclosure, the removing the base to form a first stacked structure includes: removing the base in a thinning manner; forming a second contact structure connected to the second connection terminal and a first contact structure connected to the first connection terminal, so as to form a first circuit wiring layer; and forming a first interconnection contact pad array and a second interconnection contact pad array that are connected to the first circuit wiring layer, the first interconnection contact pad array being connected to the transistor array through the first circuit wiring layer, and the second interconnection contact pad array being connected to the charge storage array through the first circuit wiring layer.

In an example embodiment of the present disclosure, the method further includes: forming a second stacked structure, and bonding the first stacked structure to the second stacked structure.

In an example embodiment of the present disclosure, the forming a second stacked structure includes: forming a control circuit on a substrate; forming a second circuit wiring layer connected to the control circuit, the second circuit wiring layer being connected to the control circuit and the substrate; and forming a third interconnection contact pad array and a fourth interconnection contact pad array that are connected to the second circuit wiring layer, the third interconnection contact pad array being connected to the control circuit through the second circuit wiring layer, and the fourth interconnection contact pad array being connected to the substrate of the charge storage array through the second circuit wiring layer.

In the embodiments of the present disclosure, the second connection terminal of the charge storage array surrounds the outer periphery of the transistor array and the charge storage array, so that not only the transistor array can be close to a bonding surface, facilitating control of the transistor array, but also the second connection terminal of the charge storage array can be ensured to be close to the bonding surface, thereby facilitating centralized control of the transistor array and the charge storage array. In addition, because the second connection terminal of the charge storage array is usually grounded, a ground terminal surrounds the transistor array and the charge storage array to shield external interference signals of the transistor array and the charge storage array, thereby improving circuit reliability.

It should be understood that the foregoing general descriptions and the following detailed descriptions are merely examples and explanations, and are not intended to limit the present disclosure.

### BRIEF DESCRIPTION OF DRAWINGS

The accompanying drawings herein, which are incorporated in and constitute a part of this specification, illustrate embodiments conforming to the present disclosure, and are utilized together with this specification to explain the principles of the present disclosure. Clearly, the accompanying drawings in the following descriptions show merely some embodiments of the present disclosure, and a person of ordinary skill in the art may still derive other drawings from these accompanying drawings without creative efforts.
FIG. 1 is a schematic structural diagram of a semiconductor structure according to an example embodiment of the present disclosure.
FIG. 2 is a schematic diagram of a first stacked structure according to an embodiment of the present disclosure.
FIG. 3A to FIG. 3D are schematic diagrams of a second connection terminal according to an embodiment of the present disclosure.
FIG. 4A and FIG. 4B are schematic diagrams of a second connection terminal and a second contact structure according to an embodiment of the present disclosure.
FIG. 5 is a schematic diagram of a first surface in the present disclosure.
FIG. 6A to FIG. 6D are schematic diagrams of a first surface according to an embodiment of the present disclosure from another perspective.
FIG. 7 is a schematic diagram of a semiconductor structure according to another embodiment of the present disclosure.
FIG. 8 is a schematic diagram of a second stacked structure according to an embodiment of the present disclosure.
FIG. 9 is a flowchart of a manufacturing method for a semiconductor structure according to an embodiment of the present disclosure.
FIG. 10A to FIG. 10G are schematic diagrams of a process of the method shown in FIG. 9.
FIG. 11A to FIG. 11C are schematic diagrams of a process of a method 900 according to another embodiment of the present disclosure.

### DESCRIPTION OF EMBODIMENTS

Now, example implementations are more comprehensively described with reference to the accompanying drawings. However, the example implementations can be implemented in multiple forms and should not be construed as a limitation to the examples described herein. Instead, these implementations are provided to make the present disclosure more comprehensive and complete, and the concept of the example implementations is comprehensively conveyed to a person skilled in the art. The described features, structures, or characteristics may be combined in one or more implementations in any suitable manner. In the following description, many specific details are provided to give a full understanding of the implementations of the present disclosure. However, a person skilled in the art will recognize that one or more of the specific details may be omitted by practicing the technical solutions of the present disclosure, or another method, component, apparatus, step, or the like may be utilized. In other cases, well-known technical solutions are not detailed or described to avoid overshadowing the aspects of the present disclosure and to prevent any ambiguity.

In addition, the accompanying drawings are merely schematic diagrams of the present disclosure, and the same reference numbers in the figure represent the same or similar parts, and therefore, repeated descriptions thereof are omitted. Some block diagrams shown in the accompanying drawings are functional entities and may not necessarily correspond to physically or logically independent entities. These functional entities may be implemented in a form of software, or these functional entities are implemented in one or more hardware modules or integrated circuits, or these functional entities are implemented in different networks and/or processor apparatuses and/or microcontroller apparatuses.

The following describes in detail example implementations of the present disclosure with reference to the accompanying drawings.

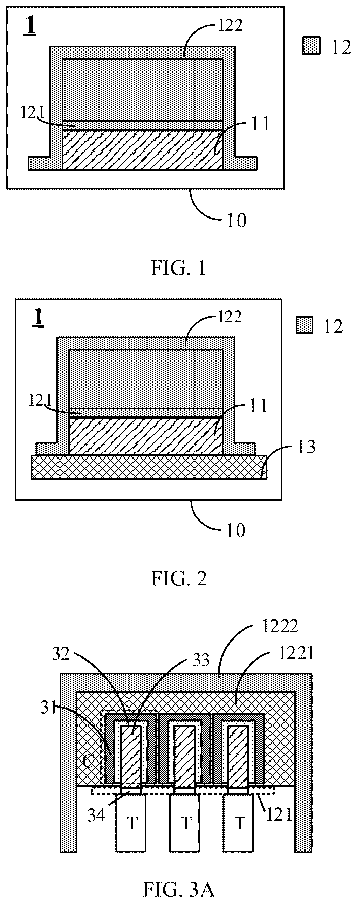

FIG. 1 is a schematic structural diagram of a semiconductor structure according to an example embodiment of the present disclosure.

Referring to FIG. 1, a semiconductor structure 100 may include:
a first stacked structure 1, the first stacked structure 1 having a first surface 10 for bonding;
the first stacked structure 1 including a transistor array 11 and a charge storage array 12, the transistor array 11 and the charge storage array 12 being stacked in a direction perpendicular to the first surface 10, and the transistor array 11 being closer to the first surface 10 than the charge storage array 12, where
the charge storage array 12 has a first connection terminal 121 and a second connection terminal 122, the first connection terminal 121 is configured to connect the charge storage array 12 and the transistor array 11, and the second connection terminal 122 surrounds the outer periphery of the transistor array 11 and the charge storage array 12 and extends to the vicinity of the first surface 10.

In this embodiment of the present disclosure, the transistor array 11 may include multiple storage transistors (not shown) disposed in parallel, and the multiple storage transistors are all vertical channel transistors (VCT). The source of each storage transistor (on one end away from the first surface 10 in a direction perpendicular to the first surface 10) is connected to a storage capacitor, and multiple storage capacitors corresponding to the multiple storage transistors jointly constitute the charge storage array 12. In some embodiments, a storage transistor and a storage capacitor form a DRAM storage unit.

The drain of each storage transistor (on one end close to the first surface 10 in the direction perpendicular to the first surface 10) is connected to a bitline. The multiple storage transistors may be connected to the same bitline, or may be connected to different bitlines. In some cases, the transistor array 11 may be a storage transistor of one or more unit storage arrays, and the unit storage array includes but is not limited to a storage array of one channel, a storage array of one rank, a storage array of one bank, a storage array of one row, and a storage array of one column.

In the charge storage array 12, the top electrodes of the multiple storage capacitors are connected to the second connection terminal 122. In some embodiments, the second connection terminal 122 is a common electrode of the multiple storage capacitors. The bottom electrodes (opposite to the top electrodes) of the multiple storage capacitors are respectively connected to the sources of corresponding storage transistors in the transistor array 11. Because the top electrode of the storage capacitor in the storage array is usually grounded, the second connection terminal 122 surrounding the outer periphery of the transistor array 11 and the charge storage array 12 is actually a ground plane.

By setting the ground plane to surround the outer periphery of the transistor array 11 and the charge storage array 12, there are at least the following benefits. First, interference of an external signal to a storage unit (including the storage transistor and the storage capacitor) can be effectively reduced, and stability and reliability of the storage unit can be improved. Second, the ground plane can be utilized as a current circuit to reduce the resistance of an interconnection path, increase a signal transmission speed, and reduce power consumption. Third, the ground plane helps heat dissipation, better conducts and disperses heat in an integrated circuit, and helps keep the operating temperature of a chip within a proper range. Finally, electromagnetic interference (EMI) generated by the storage unit can be effectively suppressed, impact of the storage unit on another circuit can be reduced, and an anti-interference capability of the entire integrated circuit can be improved.

Because the second connection terminal 122 has a relatively large area, both conductive performance and thermal conductivity thereof are better than those of a conventional capacitor electrode, which is equivalent to an increased ground area of each storage capacitor. A larger ground area can better suppress external noise and interference signals, and reduce the possibility of a charge loss in a storage capacitor. Therefore, by increasing a ground area of each storage capacitor, stability and reliability of a storage charge can be greatly improved. In addition, the storage capacitor needs to release a charge through a bitline to perform a read operation, so as to increase the ground area of the storage capacitor, thereby reducing time and power consumption required by the bitline to release the charge, that is, reducing read power consumption of the storage array. However, a write operation on the storage array needs to store a charge into the storage capacitor, so that charging efficiency of the storage capacitor can be improved by increasing the ground area of the storage capacitor, thereby increasing a write speed. Finally, a larger ground area can reduce internal noise and spurious signals, and improve signal quality. Therefore, increasing the ground area of each storage capacitor can further increase a signal-to-noise ratio of the storage unit.

In addition, control terminals of the transistor array 11 and the charge storage array 12 may be disposed on the first surface 10 at the same time by extending the second connection terminal 122 connected to the top electrodes of the multiple storage capacitors to the vicinity of the first surface 10. Therefore, after bonding of the first surface 10 is subsequently completed, the transistor array 11 and the charge storage array 12 can be controlled at the same time through the first surface 10, thereby resolving the problem that multiple structures in a vertical layout cannot be controlled at the same time.

When the transistor array 11 is a storage transistor of one or more unit storage arrays, the second connection terminal 122 may serve as a common top electrode of storage capacitors of the one or more unit storage arrays, provide an overall ground terminal for the storage capacitors of the one or more unit storage arrays, and better isolate the one or more unit storage arrays from other storage arrays, so as to optimize a data write speed, data read power, a signal transmission speed, stability and reliability of a storage charge, a signal-to-noise ratio, and the like of the one or more unit storage arrays as a whole.

FIG. 2 is a schematic diagram of a first stacked structure according to an embodiment of the present disclosure.

Referring to FIG. 2, in an embodiment, the first stacked structure 1 further includes a first circuit wiring layer 13, the first circuit wiring layer 13 is connected to the second connection terminal 122 of the charge storage array 12 and the transistor array 11, and the first circuit wiring layer 13 is closer to the first surface 10 than the transistor array 11.

The first circuit wiring layer 13 may be a re-distribution layer (RDL). The first circuit wiring layer 13 is connected to the transistor array 11 and the second connection terminal 122 at the same time. A connection manner of the first circuit wiring layer 13 and the transistor array 11 may be the same as or different from a connection manner of the first circuit wiring layer 13 and the second connection terminal 122. The first circuit wiring layer 13 includes a first contact structure required when connected to the transistor array 11, and a second contact structure required when connected to the second connection terminal 122. Materials, shapes, and forming manners of the first contact structure and the second contact structure may be the same or may be different. In some embodiments, the first circuit wiring layer 13 may further include a conductive line formed by a metal interconnection process.

In some embodiments, a transistor in the transistor array 11 is connected to a bitline (BL). In this case, a signal needing to be led out on one end of the transistor array 11 close to the first surface 10 is a bitline signal, and the first contact structure is a contact structure, such as a contact point, between the first circuit wiring layer 13 and the bitline. The material of the bitline includes a metal silicide, and the metal silicide includes but is not limited to cobalt silicide, titanium silicide, or nickel silicide. In this case, the first contact structure may be a metal-semiconductor contact structure.

In some embodiments, the second connection terminal 122 is a metal material, and the second contact structure may be a metal contact point.

In some other embodiments, the second connection terminal 122 is made of a semiconductor material. In this case, the second contact structure may be a metal-semiconductor contact structure. Based on the material of the second connection terminal 122 and the material of the bitline being the same or different, the first contact structure and the second contact structure may be the same or different.

FIG. 3A to FIG. 3D are schematic diagrams of a second connection terminal according to an embodiment of the present disclosure. The form, structure, and quantity of capacitors in the figure are merely schematic, and do not constitute a limitation on the storage capacitor.

Referring to FIG. 3A, in an embodiment, the charge storage array 12 includes multiple storage capacitors C, and the second connection terminal 122 includes:
a first conductive layer 1221, connected to top electrodes 31 of the multiple storage capacitors C; and
a second conductive layer 1222, covering and connected to the first conductive layer 1221 and surrounding the outer periphery of the transistor array 11 and the charge storage array 12.

As shown in the figure, the storage capacitor C has a top electrode 31, a dielectric layer 32, and a bottom electrode 33, the bottom electrode 33 is connected to the source of a storage transistor T through a contact pad 34, and the dielectric layer 32 is located between the top electrode 31 and the bottom electrode 33. Multiple contact pads 34 constitute the first connection terminal 121 of the charge storage array 12. The storage transistor T is a vertical channel transistor (VCT), the source thereof is connected to the contact pad 34, and the drain thereof is connected to a bitline (not shown).

In some embodiments, the material of the first conductive layer 1221 includes germanium silicon, and the material of the second conductive layer 1222 includes polysilicon. In some embodiments, the material of the second conductive layer 1222 includes metal, such as tungsten (W).

Compared with pure germanium and pure silicon, germanium silicon (Ge-Si) has higher electrical conductivity and a lower energy band gap, very good temperature stability, and higher mechanical strength and hardness. Applying germanium silicon to the first conductive layer 1221 can enable the second connection terminal 122 to have good conductivity and support performance, and have good temperature stability.

Applying polysilicon as the second conductive layer can accurately adjust the resistance value of the polysilicon by controlling the grain size and the doping concentration of the material. In addition, polysilicon has high mechanical strength and stability, and can resist impact of stress and deformation in a process, and has low manufacturing costs and is easy to process. Therefore, support performance of the second connection terminal 122 can be further enhanced without reducing conductive performance. After the area of the second connection terminal 122 is expanded, structural stability of the second connection terminal 122 is maintained, and sizes of parts are uniform, thereby improving conductive uniformity.

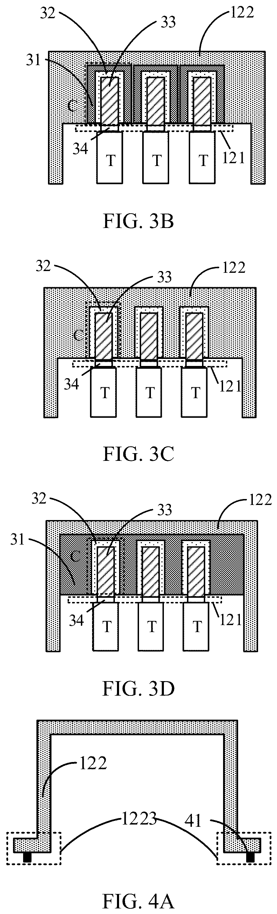

Referring to FIG. 3B, in another embodiment, the second connection terminal 122 may alternatively be directly connected to the top electrodes of the multiple storage capacitors C. In this case, the second connection terminal 122 may be formed by polysilicon.

Referring to FIG. 3C, in still another embodiment, the charge storage array 12 includes multiple storage capacitors C, the second connection terminal 122 is a common top electrode of the multiple storage capacitors C, and the material of the second connection terminal 122 is the same as the material of the bottom electrode of the storage capacitor C (an electrode configured to connect to the source of the transistor), and is a metal or a semiconductor material. The structure of the embodiment shown in FIG. 3B can shorten a process quantity, improve manufacturing efficiency, and maximize the ground area of the charge storage array 12.

Referring to FIG. 3D, in still another embodiment, the second connection terminal 122 may be further disposed to connect to the common top electrode 32 of the multiple storage capacitors C. In this case, the material of the second connection terminal 122 and the material of the top electrode 32 are a metal or a semiconductor.

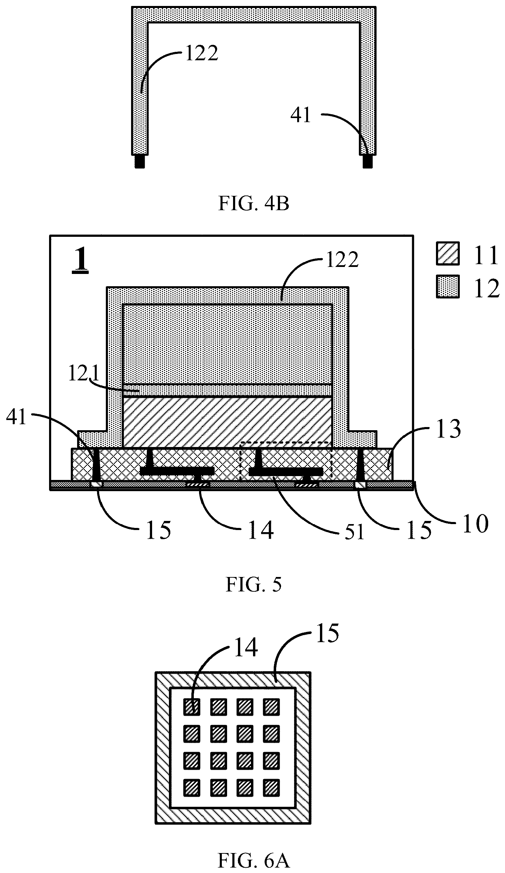

FIG. 4A and FIG. 4B are schematic diagrams of a second connection terminal and a second contact structure according to an embodiment of the present disclosure.

When the material of the second connection terminal 122 is a semiconductor material, the second contact structure is a metal-semiconductor contact structure, and may be formed in a manner such as the damascene process.

Referring to FIG. 4A, in an embodiment, the second connection terminal 122 has a brim structure 1223, so as to form a second contact structure 41. In this case, an interconnection hole aligned with the brim structure 1223 may be formed, and a conductive material is filled in the interconnection hole to form the second contact structure 41. This solution is applicable to a scenario in which the second connection terminal 122 is relatively thin in a direction parallel to the first surface 10 and is not enough to accommodate the second contact structure.

Referring to FIG. 4B, in another embodiment, the part of the second connection terminal 122 close to the first surface 10 does not have a special design. In a case in which the operation width permits, an interconnection hole aligned with the second connection terminal 122 may be directly formed, and a conductive material is filled in the interconnection hole to form the second contact structure 41. This solution is applicable to a scenario in which the second connection terminal 122 is relatively thick in the direction parallel to the first surface 10.

Depending on the material and shape of the second connection terminal 122, there may be various types of second contact structures, which are not listed herein.

FIG. 5 is a schematic diagram of a first surface in the present disclosure.

Referring to FIG. 5, in an embodiment, the first surface 10 has a first interconnection contact pad array 14 connected to the transistor array 11 and a second interconnection contact pad array 15 connected to the second connection terminal 122, the first interconnection contact pad array 14 extends through the first surface 10 to connect to the transistor array 11, and the second interconnection contact pad array 15 extends through the first surface 10 to connect to the second connection terminal 122.

FIG. 5 shows a case in which a first circuit wiring layer 13 exists. In this case, the first interconnection contact pad array 14 extends through the first surface 10 to connect to the transistor array 11 via the first circuit wiring layer 13, and the second interconnection contact pad array 15 extends through the first surface 10 to connect to the second connection terminal 122 via the first circuit wiring layer 13.

In some embodiments, the first interconnection contact pad array 14 extends through the first surface 10 to connect to the transistor array 11 via the first contact structure 51 in the first circuit wiring layer 13, and the second interconnection contact pad array 15 extends through the first surface 10 to connect to the second connection terminal 122 via the second contact structure 41 in the first circuit wiring layer 13. The first contact structure 51 may include only contact points, or may include an interconnection hole and a conductive line between contact points.

The first surface 10 is subsequently configured to perform hybrid bonding, and has a very high interface flatness requirement and dishing requirement. Ideally, the first interconnection contact pad array 14 and the second interconnection contact pad array 15 are flush with the first surface 10. Regarding the setting of a processing error, the first interconnection contact pad array 14 and the second interconnection contact pad array 15 may have a concave or convex with a defined range relative to the first surface 10, and the range is 0-20 nm, so as to keep the first surface 10 as smooth as possible.

In another embodiment, the first circuit wiring layer 13 may alternatively not exist, the first interconnection contact pad array 14 extends through the first surface 10 to directly connect to the transistor array 11, and the second interconnection contact pad array 15 extends through the first surface 10 to directly connect to the second connection terminal 122.

The first interconnection contact pad array 14 and the second interconnection contact pad array 15 that are disposed on the first surface 10 are configured to be subsequently bonded to another structure.

FIG. 6A to FIG. 6D are schematic diagrams of a first surface according to an embodiment of the present disclosure from another perspective. The shape and quantity of the first interconnection contact pad array 14 and the second interconnection contact pad array 15 in the figure are merely schematic, which are configured to describe a relative position relationship between the first interconnection contact pad array 14 and the second interconnection contact pad array 15, and do not constitute a limitation on the actual structure, quantity, and internal arrangement of the first interconnection contact pad array 14 and the second interconnection contact pad array 15.

In this embodiment of the present disclosure, the second interconnection contact pad array 15 is formed on the outer periphery of the first interconnection contact pad array 14.

Referring to FIG. 6A, in an embodiment, the second connection terminal 122 is disposed around the transistor array 11, and in this case, the second interconnection contact pad array 15 surrounds the first interconnection contact pad array 14 by one round to form complete shielding for the first interconnection contact pad array 14.

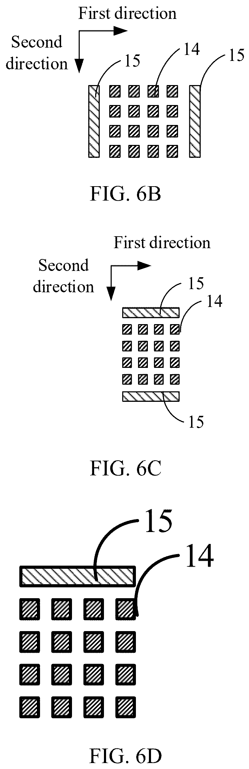

Referring to FIG. 6B and FIG. 6C, in some other embodiments, the second connection terminal 122 is disposed on each of only two sides of the transistor array 11. Correspondingly, the second interconnection contact pad array 15 is disposed on each of both sides of the first interconnection contact pad array 14, which may be both sides in the first direction or both sides in the second direction. In this way, manufacturing efficiency can be improved, and shielding in an opposite direction can be implemented. Disposing the second connection terminal 122 on two sides in which direction may depend on the integrated circuit layout.

Referring to FIG. 6D, in still some other embodiments, the second connection terminal 122 may be disposed on only one side of the transistor array 11. Correspondingly, the second interconnection contact pad array 15 is disposed on one side of the first interconnection contact pad array 14, so as to reduce processing difficulty and improve manufacturing efficiency. Disposing the second connection terminal 122 in which direction may depend on the integrated circuit layout.

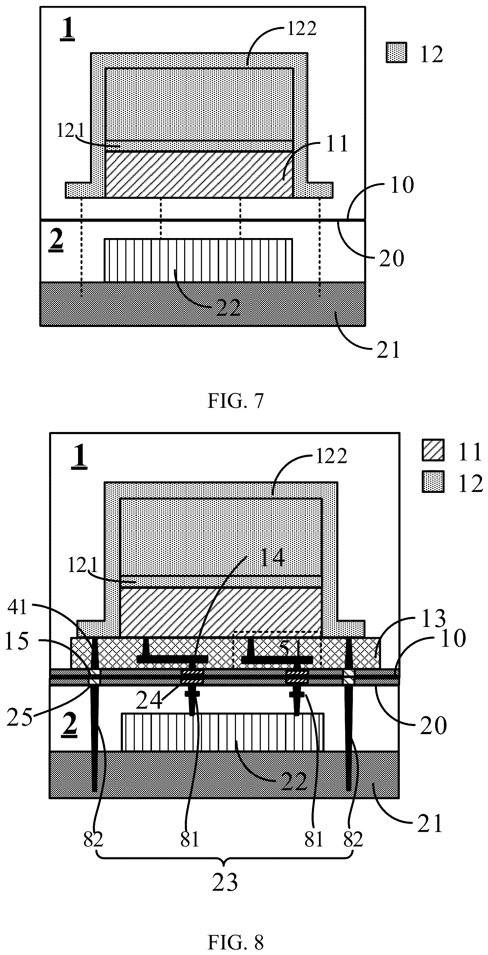

FIG. 7 is a schematic diagram of a semiconductor structure according to another embodiment of the present disclosure.

Referring to FIG. 7, in another embodiment, the semiconductor structure 100 further includes a second stacked structure 2, the second stacked structure 2 has a second surface 20, and the second surface 20 of the second stacked structure 2 is configured to bond to the first surface 10 of the first stacked structure 1.

In the embodiment shown in FIG. 7, the second stacked structure 2 includes a substrate 21 and a control circuit 22 disposed on the substrate 21, the control circuit 22 is closer to the second surface 20 of the second stacked structure 2 than the substrate 21, the control circuit 22 is configured to connect to the transistor array 11, and the substrate 21 is configured to connect to the second connection terminal 122 of the charge storage array 12. It may be understood that the control circuit 22 includes multiple transistors and other electronic elements.

By bonding the second stacked structure 2 to the first stacked structure 1, the volume of a memory can be reduced. By connecting the substrate 21 in the second stacked structure 2 to the second connection terminal 122 of the charge storage array 12 in the first stacked structure 1, a better ground connection can be provided to the charge storage array 12, so that the second stacked structure 2 performs better control on the first stacked structure 1.

FIG. 8 is a schematic diagram of a second stacked structure according to an embodiment of the present disclosure.

Referring to FIG. 8, in an embodiment, the second stacked structure 2 further includes a second circuit wiring layer 23, the second circuit wiring layer 23 is connected to the control circuit 22 and the substrate 21, and the second circuit wiring layer 23 is closer to the second surface 20 of the second stacked structure 2 than the control circuit 22. The second circuit wiring layer 23 may also be a re-distribution layer.

In addition, in some embodiments, a third interconnection contact pad array 24 and a fourth interconnection contact pad array 25 are disposed on the second surface 20 of the second stacked structure 2, the third interconnection contact pad array 24 is configured to connect the transistor array 11 and the control circuit 22, and the fourth interconnection contact pad array 25 is configured to connect the second connection terminal 122 of the charge storage array 12 and the substrate 21.

The second circuit wiring layer 23 may include a third contact structure 81 and a fourth contact structure 82. The third contact structure 81 is configured to connect the third interconnection contact pad array 24 and the control circuit 22, and the fourth contact structure 82 is configured to connect the fourth interconnection contact pad array 25 and the substrate 21. It may be learned from FIG. 8 that the length of the fourth contact structure 82 is greater than the length of the third contact structure 81. The fourth contact structure 82 may probe into the substrate 21, which is implemented by manufacturing a through silicon via (TSV) on the substrate 21, so that a signal of the second connection terminal 122 is subsequently led from the back of the substrate 21 to a chip package on the back of the substrate 21 through a contact pad, the fourth contact structure 82, and the second contact structure 41.

Same as the relative position relationship between the first interconnection contact pad array 14 and the second interconnection contact pad array 15, the fourth interconnection contact pad array 25 may also surround the third interconnection contact pad array 24. When the first interconnection contact pad array 14 and the second interconnection contact pad array 15 are in other relative position relationships shown in FIG. 6A to FIG. 6D, the third interconnection contact pad array 24 and the fourth interconnection contact pad array 25 are also in a corresponding position relationship, and details are not described again.

The second surface 20 is subsequently configured to perform hybrid bonding, and has a very high interface flatness requirement and dishing requirement. Ideally, the third interconnection contact pad array 24 and the fourth interconnection contact pad array 25 are flush with the second surface 20. Regarding the setting of the processing error, the third interconnection contact pad array 24 and the fourth interconnection contact pad array 25 may have a concave or convex with a defined range relative to the second surface 20, and the range is 0-20 nm, so as to keep the second surface 20 as smooth as possible.

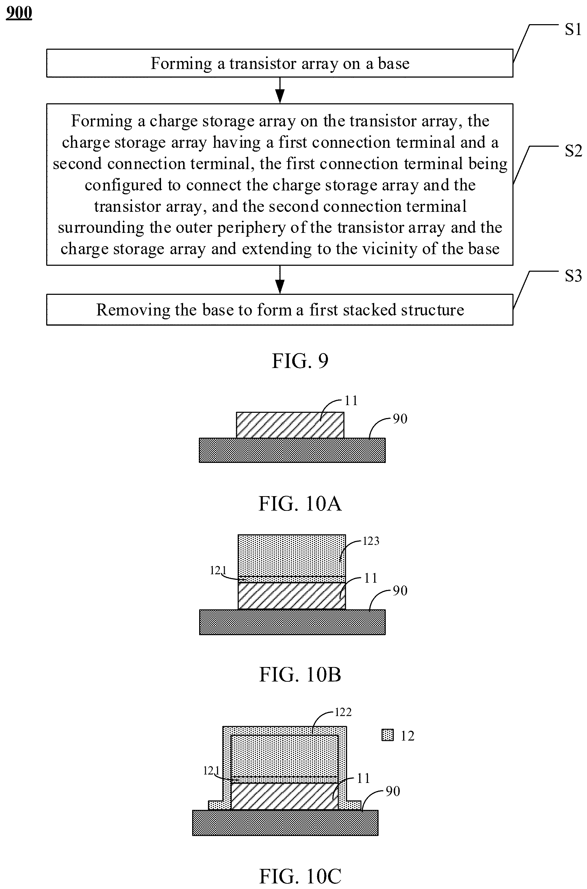

FIG. 9 is a flowchart of a manufacturing method for a semiconductor structure according to an embodiment of the present disclosure.

Referring to FIG. 9, a manufacturing method 900 may be configured to manufacture the semiconductor structure according to any one of the foregoing embodiments, including:

In the step of S1, a transistor array 11 is formed on a base.

In the step of S2, a charge storage array 12 is formed on the transistor array 11, the charge storage array 12 having a first connection terminal 121 and a second connection terminal 122, the first connection terminal 121 being configured to connect the charge storage array 12 and the transistor array 11, and the second connection terminal 122 surrounding the outer periphery of the transistor array 11 and the charge storage array 12 and extending to the vicinity of the base.

In the step of S3, the base is removed to form a first stacked structure 1.

FIG. 10A to FIG. 10G are schematic diagrams of a process of the method shown in FIG. 9.

Referring to FIG. 10A, in the step of S1, the transistor array 11 is formed on the base. A process of photolithography, deposition, or the like may be performed on the base 90 to form a bitline corresponding to multiple vertical channel transistors, the multiple vertical channel transistors connected to the bitline, and a word line connected to the multiple vertical channel transistors, to form multiple storage transistors connected to the word line and the bitline. FIG. 10A is only schematic because a transistor manufacturing process is not an improvement direction in this embodiment of the present disclosure.

Referring to FIG. 10B, in the step of S2, the charge storage array 12 is formed on the transistor array 11, the charge storage array 12 having the first connection terminal 121 and the second connection terminal 122, the first connection terminal 121 being configured to connect the charge storage array 12 and the transistor array 11, and the second connection terminal 122 surrounding the outer periphery of the transistor array 11 and the charge storage array 12 and extending to the vicinity of the base 90. The manufacturing process may be that multiple transistor-capacitor contact structures are first formed on the basis of the transistor array 11, so as to form the first connection terminal 121 including multiple transistor-capacitor contact structures. Next, the bottom electrode of the storage capacitor is formed on each transistor-capacitor contact structure (refer to the bottom electrode 33 in FIG. 3A), then a dielectric layer of the storage capacitor is formed on the basis of the bottom electrode (refer to the dielectric layer 32 in FIG. 3A), and finally the top electrode of the storage capacitor is formed on the basis of the dielectric layer (refer to the top electrode 31 in FIG. 3A to FIG. 3D), to form the storage capacitor array 123. In this embodiment of the present disclosure, the storage capacitor array 123 may include a part of the second connection terminal 122 (the second connection terminal 122 is a common top electrode of multiple storage capacitors), or may be independent from the second connection terminal 122.

Referring to FIG. 10C, when multiple storage capacitors share the top electrode and the top electrode is the second connection terminal 122, manufacturing of the second connection terminal 122 may be completed through one-time processing (including a process such as etching, deposition, and CMP polishing). When multiple storage capacitors share the top electrode and the top electrode is connected to the second connection terminal 122, the second connection terminal 122 may be formed after the top electrode is formed. When multiple storage capacitors have respective top electrodes, a gap between the multiple storage capacitors needs to be filled after multiple top electrodes of the multiple storage capacitors are formed, and then the second connection terminal 122 is formed on the filled structural body. Finally, the charge storage array 12 is formed.

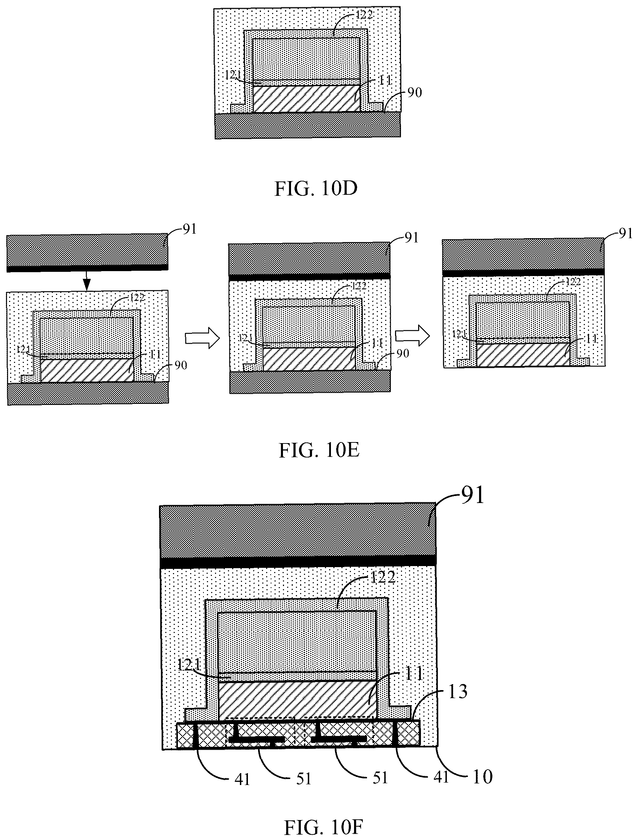

Referring to FIG. 10D, an insulating material is deposited on the charge storage array 12 to form a structural body. The insulating material may be an oxide, such as silicon dioxide. Then chemical mechanical polishing (CMP) is performed to smooth the upper surface of the structural body.

Referring to FIG. 10E, in the step of S3, a carrier wafer 91 is introduced, and the upper surface of the structural body is fixed through the carrier wafer 91, so that the base 90 is removed in a thinning manner, thereby facilitating subsequent processing. The carrier wafer is a wafer with a large size that is configured to support and carry a chip in semiconductor manufacturing, and is configured to accommodate and support multiple chips in the manufacturing process. The carrier wafer 91 may be bonded to the upper surface of the structural body to complete fixation. A manner of thinning the base 90 on the backside of the structural body (backside silicon thinning) includes but is not limited to steps such as mechanical grinding and chemical mechanical polishing, to expose a part of each of the transistor array 11 and the second connection terminal 122.

Referring to FIG. 10F, after the base 90 is removed in the thinning manner, a second contact structure connected to the second connection terminal 122 and a first contact structure connected to the first connection terminal 121 are formed on the basis of exposing a part of each of the transistor array 11 and the second connection terminal 122, so as to form a first circuit wiring layer 13.

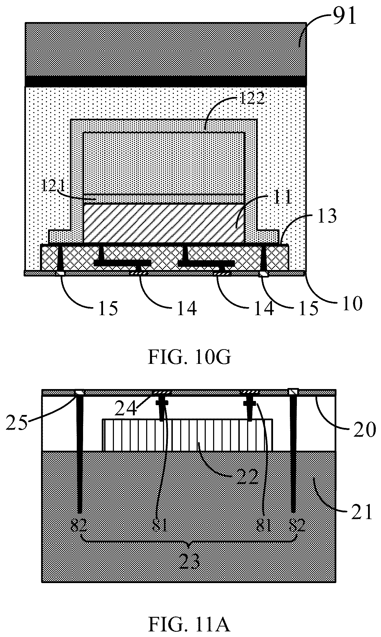

Referring to FIG. 10G, next, a first interconnection contact pad array 14 and a second interconnection contact pad array 15 that are connected to the first circuit wiring layer 13 are formed, the first interconnection contact pad array 14 being connected to the transistor array 11 through the first circuit wiring layer 13, and the second interconnection contact pad array 15 being connected to the charge storage array 12 through the first circuit wiring layer 13. Specifically, the first interconnection contact pad array 14 and the second interconnection contact pad array 15 may be formed through the dual damascene process. After a re-distribution layer (RDL) is formed, the first interconnection contact pad array 14 and the second interconnection contact pad array 15 may be manufactured, so as to directly interconnect the first stacked structure and the second stacked structure, and establish a high-speed signal transmission channel.

FIG. 11A to FIG. 11C are schematic diagrams of a process of a method 900 according to another embodiment of the present disclosure.

In some embodiments, the method 900 further includes step S4 of forming a second stacked structure 2, the second stacked structure 2 including a control circuit 22 corresponding to the transistor array 11; and step of S5 bonding the first stacked structure 1 to the second stacked structure 2.

Referring to FIG. 11A, in the step of S4, the control circuit 22 may be first formed on the substrate 21, then an insulating material is deposited, and a second circuit wiring layer 23 connected to the control circuit 22 is formed on the structural body formed after the deposition. The second circuit wiring layer 23 is connected to the control circuit 22 and the substrate 21, and includes a third contact structure 81 connected to the control circuit 21 and a fourth contact structure 82 connected to the substrate 21. The fourth contact structure 82 may partially include a through silicon via (TSV) embedded in the substrate 21. Next, a third interconnection contact pad array 24 and a fourth interconnection contact pad array 25 that are connected to the second circuit wiring layer 23 are formed. The third interconnection contact pad array 24 is connected to the control circuit 22 through the third contact structure 81 in the second circuit wiring layer 23, and the fourth interconnection contact pad array 25 is connected to the substrate 21 through the fourth contact structure 82 in the second circuit wiring layer 23. In this way, the second stacked structure 2 and a second surface 20 thereof are formed.

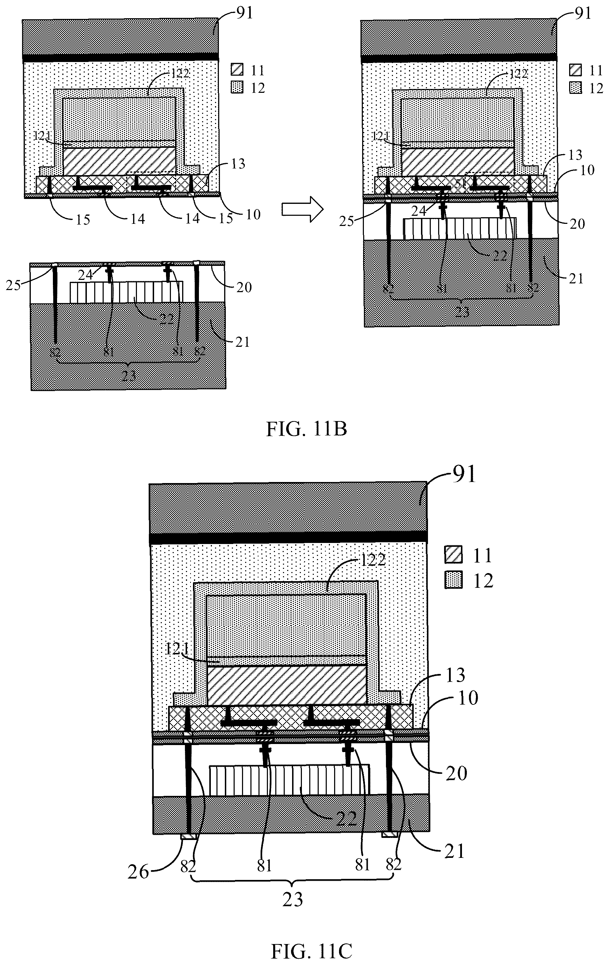

Referring to FIG. 11B, in the step of S5, the first surface 10 of the first stacked structure 1 and the second surface 20 of the second stacked structure 2 may be bonded in a hybrid bonding manner. A metal bonding or an intermetallic compound bonding method is usually applied for hybrid bonding. In this embodiment of the present disclosure, the third interconnection contact pad array 24 and the fourth interconnection contact pad array 25 are respectively bonded to the first interconnection contact pad array 14 and the second interconnection contact pad array 15.

Referring to FIG. 11C, finally, thinning and BVR& Al PAD processing may be performed on the substrate 21. "BVR & Al PAD" means "backside via reveal and aluminum pad", that is, the step of exposing a backside via and an aluminum pad.

This step includes the following operations:
Backside via reveal (BVR): First, a via etching step is performed on the backside of the substrate 21 to form a required via structure. These vias may be applied for electrical connection, heat dissipation, or other specific purposes. The position and layout of the via are determined according to the design requirements.

Aluminum pad (Al PAD): Next, a layer of aluminum metal is coated around the backside via to form an aluminum pad 26. The aluminum pad functions to provide a reliable electrical connection point to connect components such as a backside via and a package substrate of an integrated circuit.

By performing the step of BVR and Al PAD, a via may be formed on the backside of the substrate 21, and the aluminum pad 26 is created around the via, so as to implement electrical connection and other functional requirements for advanced packaging and manufacturing of a three-dimensional integrated circuit (3D-IC).

According to the implementations of the present disclosure, features and functions of two or more modules or units described above may be embodied in one module or unit. On the contrary, features and functions of one module or unit described above may be further divided into multiple modules or units to be embodied.

A person skilled in the art can easily figure out other implementation solutions of the present disclosure after considering the specification and practice of the present disclosure herein. This application is intended to cover any variations, functions, or adaptive changes of the present disclosure. These variations, functions, or adaptive changes comply with general principles of the present disclosure, and include common knowledge or a conventional technical means in the art that is not disclosed in the present disclosure. The specification and embodiments are merely considered to be exemplary, and the true scope and conception of the present disclosure are pointed out by the claims.

## Claims

1. A semiconductor structure, comprising:
a first stacked structure (1), the first stacked structure (1) having a first surface (10) for bonding;
the first stacked structure (1) comprising a transistor array (11) and a charge storage array (12), the transistor array (11) and the charge storage array (12) being stacked in a direction perpendicular to the first surface (10), and the transistor array (11) being closer to the first surface (10) than the charge storage array (12), wherein
the charge storage array (12) has a first connection terminal (121) and a second connection terminal (122), the first connection terminal (121) is configured to connect the charge storage array (12) and the transistor array (11), and the second connection terminal (122) surrounds an outer periphery of the transistor array (11) and the charge storage array (12) and extends to the vicinity of the first surface (10).

2. The semiconductor structure according to claim 1, wherein the first stacked structure further comprises a first circuit wiring layer, the first circuit wiring layer is connected to the second connection terminal of the charge storage array and the transistor array, and the first circuit wiring layer is closer to the first surface than the transistor array.

3. The semiconductor structure according to claim 1, wherein the first surface has a first interconnection contact pad array connected to the transistor array and a second interconnection contact pad array connected to the second connection terminal, the first interconnection contact pad array extends through the first surface to connect to the transistor array, and the second interconnection contact pad array extends through the first surface to connect to the second connection terminal.

4. The semiconductor structure according to claim 3, wherein the second interconnection contact pad array is formed on an outer periphery of the first interconnection contact pad array.

5. The semiconductor structure according to claim 1, wherein the charge storage array comprises a plurality of storage capacitors, and the second connection terminal comprises:
a first conductive layer, connected to top electrodes of the plurality of storage capacitors; and
a second conductive layer, covering and connected to the first conductive layer and surrounding the outer periphery of the transistor array and the charge storage array.

6. The semiconductor structure according to claim 1, further comprising a second stacked structure, wherein the second stacked structure has a second surface, and the second surface of the second stacked structure is configured to bond to the first surface of the first stacked structure.

7. The semiconductor structure according to claim 6, wherein the second stacked structure comprises a substrate and a control circuit disposed on the substrate, the control circuit is closer to the second surface of the second stacked structure than the substrate, the control circuit is configured to connect to the transistor array, and the substrate is connected to the second connection terminal of the charge storage array.

8. The semiconductor structure according to claim 7, wherein the second stacked structure further comprises a second circuit wiring layer, the second circuit wiring layer is connected to the control circuit and the substrate, and the second circuit wiring layer is closer to the second surface of the second stacked structure than the control circuit.

9. The semiconductor structure according to claim 7, wherein a third interconnection contact pad array and a fourth interconnection contact pad array are disposed on the second surface of the second stacked structure, the third interconnection contact pad array is configured to connect the transistor array and the control circuit, and the fourth interconnection contact pad array is configured to connect the second connection terminal of the charge storage array and the substrate.

10. The semiconductor structure according to claim 9, wherein the fourth interconnection contact pad array surrounds the third interconnection contact pad array.

11. The semiconductor structure according to claim 9, wherein a second circuit wiring layer comprises a third contact structure and a fourth contact structure, the third contact structure is configured to connect the third interconnection contact pad array and the control circuit, and the fourth contact structure is configured to connect the fourth interconnection contact pad array and the substrate.

12. A manufacturing method for a semiconductor structure, comprising:
forming a transistor array on a base;
forming a charge storage array on the transistor array, the charge storage array having a first connection terminal and a second connection terminal, the first connection terminal being configured to connect the charge storage array and the transistor array, and the second connection terminal surrounding an outer periphery of the transistor array and the charge storage array and extending to the vicinity of the base; and
removing the base to form a first stacked structure.

13. The manufacturing method according to claim 12, wherein the removing the base to form a first stacked structure comprises:
removing the base in a thinning manner;
forming a second contact structure connected to the second connection terminal and a first contact structure connected to the first connection terminal, so as to form a first circuit wiring layer; and
forming a first interconnection contact pad array and a second interconnection contact pad array that are connected to the first circuit wiring layer, the first interconnection contact pad array being connected to the transistor array through the first circuit wiring layer, and the second interconnection contact pad array being connected to the charge storage array through the first circuit wiring layer.

14. The manufacturing method according to claim 12, further comprising:
forming a second stacked structure, and bonding the first stacked structure to the second stacked structure.

15. The manufacturing method according to claim 14, wherein the forming a second stacked structure comprises:
forming a control circuit on a substrate;
forming a second circuit wiring layer connected to the control circuit, the second circuit wiring layer being connected to the control circuit and the substrate; and
forming a third interconnection contact pad array and a fourth interconnection contact pad array that are connected to the second circuit wiring layer, the third interconnection contact pad array being connected to the control circuit through the second circuit wiring layer, and the fourth interconnection contact pad array being connected to the substrate of the charge storage array through the second circuit wiring layer.

16. The semiconductor structure according to claim 1, wherein the transistor array comprises a plurality of storage transistors disposed in parallel, each of the storage transistors is a vertical channel transistor, the storage transistor has a source on one end away from the first surface in a direction perpendicular to the first surface, and the source is connected to the charge storage array.

17. The semiconductor structure according to claim 16, wherein the first stacked structure further comprises a bitline, the storage transistor has a drain on one end close to the first surface in the direction perpendicular to the first surface, and the drain is connected to the bitline.

18. The semiconductor structure according to claim 2, wherein the first circuit wiring layer comprises a first contact structure and a second contact structure, the first contact structure is connected to the transistor array, and the second contact structure is connected to the second connection terminal.

19. The semiconductor structure according to claim 7, wherein a contact pad is formed on a back of the substrate, and the contact pad is connected to the second connection terminal.

20. The semiconductor structure according to claim 18, wherein the second connection terminal has a brim structure, the brim structure is closer to the first surface than the first connection terminal, and the second contact structure is connected to the brim structure.
